# FASCICULE DE BREVET EUROPEEN

(11) **EP 0 359 606 B1**
(45) Date de publication et mention de la délivrance du brevet: **27.10.1993**
(21) Numéro de dépôt: 89402223.5
(22) Date de dépôt: 04.08.1989
(51) Int. Cl.: H05K 5/00, H05K 7/20

(54) **Boîtier pour circuits électroniques notamment pour véhicule automobile**
Gehäuse für elektronische Schaltungen, insbesondere für Kraftfahrzeuge
Casing for electronic circuits, especially for a motor vehicle

(30) Priorité: 15.09.1988 FR 8812041
(43) Date de publication de la demande: 21.03.1990
(73) Titulaire: AUTOMOBILES PEUGEOT, 75116 Paris (FR); AUTOMOBILES CITROEN, 92200 Neuilly-sur-Seine (FR)
(72) Inventeur: Quentric, René, F-78640 Neauphle le Château (FR); Celnik, Jean, F-75013 Paris (FR)
(74) Mandataire: Moncheny, Michel

(56) Documents cités:
- EP-A- 0 113 073
- WO-A-88/09058
- DE-A- 3 048 451
- FR-A- 2 483 730

## Description

La présente invention concerne un boîtier pour circuits électroniques notamment pour véhicule automobile.

Dans l'état de la technique, les boîtiers pour circuits électroniques sont généralement constitués de plusieurs pièces assemblées les unes aux autres pour former une enceinte protectrice de la fonction électronique.

Ainsi par exemple, ces boîtiers comportent :
- un support d'un réseau d'interconnexion de composants électroniques, constitué par une plaque de circuit imprimé,
- des éléments d'enceinte comprenant un fond, un couvercle et une ceinture,
- des éléments de connexion externe pour le raccordement du boitier au reste des circuits du véhicule,
- des éléments de connexion interne entre les éléments de connexion externe et le circuit d'interconnexion des composants, et
- un dissipateur thermique quand la fonction l'exige.

L'assemblage de ces différents organes conduit à la réalisation de boîtiers de forme généralement parallélépipédique à fond plat, ceci afin de les disposer par exemple sur des surfaces planes pour des commodités de fixation, de refroidissement, etc.

Cependant, cet assemblage présente un certain nombre d'inconvénients en raison du grand nombre de pièces à assembler, des nombreux raccordements d'éléments et de la faible capacité d'adaptation de ces boîtiers.

On connaît également par exemple des documents WO-A-88 09058 (cité selon l'article 54(3) CBE) et FR-A-2 483 730 des boîtiers pour circuits électroniques notamment pour véhicule automobile, du type comportant une plaque de fond, un couvercle, un circuit imprimé et au moins un connecteur de raccordement comportant des broches de liaison du circuit disposé dans le boîtier au reste des circuits du véhicule.

Le but de l'invention est donc de résoudre ces problèmes en proposant un boitier dans lequel tous les organes cités ci-dessus peuvent être réduits à la limite à une seule pièce de manière à faciliter la fabrication et le montage de ce boîtier et que la forme de celui-ci puisse être adaptée facilement à la forme de la surface qui le reçoit et sur laquelle il peut être fixé.

A cet effet, l'invention a pour objet un boîtier pour circuits électroniques notamment pour véhicule automobile, du type comportant une plaque de fond, un couvercle, un circuit imprimé, au moins un connecteur de raccordement comportant des broches de liaison du circuit disposé dans le boîtier au reste des circuits du véhicule, le circuit imprimé étant disposé sur l'une des faces de la plaque de fond, les broches de liaison s'étendent dans la plaque de fond, l'une de leurs extrémités étant raccordée directement au circuit disposé dans le boîtier, tandis que leur autre extrémité fait saillie à partir de cette plaque à l'extérieur du boîtier pour permettre le raccordement, le boîtier comportant une première partie obtenue par moulage d'une seule pièce de la plaque de fond et des connecteurs électriques, cette plaque de fond étant surmoulée autour des broches de liaison et un dissipateur thermique étant prévu sur la face de la plaque de fond opposée à celle sur laquelle est prévu le circuit imprimé, la plaque de fond étant surmoulée autour de ce dissipateur.

Des autres formes de mise en oeuvre avantageuses de l'invention sout définies dans les revendications dépendantes.

L'invention sera mieux comprise à l'aide de la description qui va suivre, donnée uniquement à titre d'exemple et faite en se référant aux dessins annexés, sur lesquels :
- la Fig. 1 représente un boitier pour circuits électroniques de l'état de la technique;
- la Fig.2 représente un mode de réalisation d'un boitier pour circuits électroniques selon l'invention.

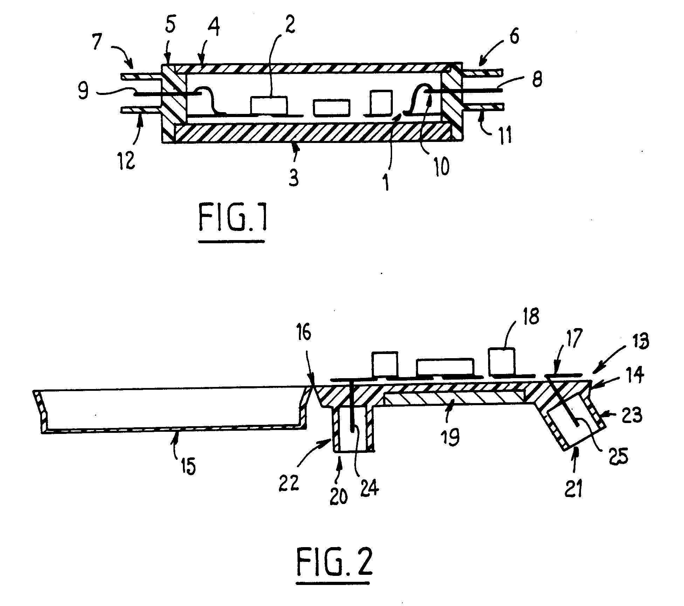

Ainsi qu'on peut le voir sur la Fig.1, un boitier pour circuits électroniques de l'état de la technique, comporte un circuit 1 d'interconnexion de composants électroniques, constitué par exemple par une plaque de circuit imprimé sur laquelle sont disposés des composants électroniques 2. Cette plaque est fixée par tout moyen approprié sur une plaque de fond 3 de boîtier pouvant par exemple être constituée par un dissipateur thermique.

Dans ce cas, un isolant peut être interposé entre la plaque de circuit imprimé et le dissipateur thermique. Ce fond 3 constitue avec un couvercle 4 et une ceinture 5, l'enceinte protectrice des différents composants électroniques et de la plaque de circuit imprimé.

Le raccordement des circuits électroniques de ce boîtier au reste des circuits par exemple du véhicule automobile, est réalisé par l'intermédiaire de connecteurs, dont deux respectivement 6 et 7 sont représentés sur cette figure. Ces connecteurs comportent des broches de liaison 8,9 respectivement, constituant des connexions externes du boîtier et permettant le raccordement des composants du boîtier au reste des circuits du véhicule.

Ces broches traversent la ceinture 5 du boîtier et sont reliées par des connexions internes 10 au circuit imprimé de la plaque. Ces connexions internes sont constituées par exemple par des fils de liaison soudés à l'une de leurs extrémités sur la plaque de circuit imprimé et à l'autre extrémité à une broche de liaison 8 ou 9.

Dans ce mode de réalisation, les connecteurs électriques 6 et 7 comportent également des moyens de guidage 11 et 12 de fiches de forme complémentaire à ces connecteurs pour assurer un bon positionnement et un maintien en position de ces fiches.

Comme on peut le voir sur la Fig.2, qui représente un mode de réalisation d'un boîtier selon l'invention, celui-ci comporte un ensemble monobloc 13 comportant une première partie 14 formant plaque de fond d'un boîtier et une seconde partie 15 formant couvercle, articulée en 16 sur la première partie, par exemple par l'intermédiaire d'une portion de section réduite.

Avantageusement, cet ensemble monobloc 13 est obtenu par moulage par exemple de matière plastique ou autre.

La première partie 14 de cet ensemble présente une face par exemple plane sur laquelle est prévu un circuit imprimé 17 muni lui-même de composants électroniques 18.

Ce circuit imprimé peut par exemple être formé sur une plaque séparée de la plaque de fond et fixée sur celle-ci par tout moyen approprié, ou par un circuit obtenu par croissance additive sur cette plaque de fond. Un dissipateur thermique 19 est également prévu dans cette première partie 14 sur la face de la plaque de fond opposée à celle sur laquelle est prévu le circuit imprimé 17.

Des connecteurs de raccordement 20 et 21 sont également prévus sur la plaque de fond. Ces connecteurs s'étendent à partir de la face de celle-ci opposée à celle sur laquelle est prévu le circuit imprimé. Ces connecteurs comportent des moyens de guidage 22, 23 respectivement de fiches de raccordement de forme complémentaire, constitués par exemple par des parties en saillie venues de matière avec la plaque de fond lors du moulage de l'ensemble monobloc 13.

Des broches de liaison respectivement 24 et 25 sont également insérées dans cette plaque de fond et traversent celle-ci pour faire saillie à partir de cette plaque de fond à l'extérieur du boîtier, de manière à permettre leur raccordement, tandis que leur autre extrémité est directement reliée au circuit imprimé. Il est à noter que ces broches de liaison en saillie peuvent être coudées ou non et s'étendre perpendiculairement à la face correspondante de la plaque de fond du boîtier ou non, en fonction des modes de fixation et/ou de raccordement du circuit de ce boîtier au reste des circuits du véhicule.

On conçoit donc que le boîtier se présente sous la forme d'une pièce monobloc comportant une partie formant plaque de fond du boîtier, et une autre partie formant couvercle de celui-ci, la partie formant plaque de fond étant surmoulée autour du dissipateur thermique, et de broches de liaison, de manière à simplifier la fabrication et le montage de ces boîtiers.

Selon un autre mode de realisation ce boitier peut également comporter des broches de liaison coudées faisant saillie à partir de parois latérales de la plaque de fond, ceci afin de permettre une adaptation de forme de la face de la plaque de fond, opposée à la face de celle-ci sur laquelle est disposé le circuit imprimé, à la forme d'une pièce sur laquelle doit être fixé ce boîtier.

Bien entendu, les connecteurs peuvent également comporter des moyens de guidage constitués par des parties en saillie à partir d'une face latérale correspondante du boîtier ou des décrochements ménagés dans celle-ci.

Il est à noter que le raccordement des broches de liaison des connecteurs et du circuit imprimé disposé dans le boitier peut être réalisé par recharge galvanique, par des entres conductrices, par crème à braser ou autre.

Le boitier selon l'invention se présente donc sous la forme d un ensemble monobloc dont le montage est très facile et très rapide.

## Revendications

1. Boîtier pour circuits électroniques notamment pour véhicule automobile, du type comportant une plaque de fond (14), un couvercle (15), un circuit imprimé (17), au moins un connecteur de raccordement (20,21) comportant des broches de liaison (24,25) du circuit disposé dans le boîtier au reste des circuits du véhicule, le circuit imprimé (17) étant disposé sur l'une des faces de la plaque de fond, les broches de liaison (24,25) s'étendant dans la plaque de fond, l'une de leurs extrémités étant raccordée directement au circuit disposé dans le boîtier, tandis que leur autre extrémité fait saillie à partir de cette plaque (14) à l'extérieur du boîtier pour permettre le raccordement, le boîtier comportant une première partie (13) obtenue par moulage d'une seule pièce de la plaque de fond (14) et des connecteurs électriques (20,21), cette plaque de fond étant surmoulée autour des broches de liaison (24,25) et un dissipateur thermique (19) étant prévu sur la face de la plaque de fond (14) opposée à celle sur laquelle est prévu le circuit imprimé (17), la plaque de fond étant surmoulée autour de ce dissipateur.

2. Boitier selon la revendication 1, caractérisé en ce que lesdites broches (24,25) font saillie à partir de la face de la plaque de fond (14) opposée à celle sur laquelle est disposé le circuit (17).

3. Boîtier selon la revendication 1, caractérisé en ce que lesdites broches sont coudées.

4. Boîtier selon la revendication 3, caractérisé en ce que lesdites broches font saillie à partir d'une face latérale de la plaque de fond.

5. Boîtier selon l'une quelconque des revendications 2,3 ou 4, caractérisé en ce que lesdites broches (24,25) font saillie perpendiculairement ou non à partir de ladite face de la plaque de fond.

6. Boîtier selon l'une quelconque des revendications précédentes, caractérisé en ce que la face de la plaque de fond opposée à celle sur laquelle est disposé le circuit imprimé, présente une forme adaptée à celle d'une pièce sur laquelle est fixé le boîtier.

7. Boîtier selon l'une quelconque des revendications précédentes, caractérisé en ce que le boitier comporte une seconde partie comprenant le couvercle (15) moulé d'une seule pièce avec la plaque de fond (14), et relié à celle-ci par une zone de section réduite formant articulation (16).

## Claims

1. A casing for electronic circuits, particularly for motor vehicles, of a type comprising a base plate (14), a cover (15), a printed circuit (17) and at least one connector (20, 21) comprising pins (24, 25) for connecting the circuit provided in the casing to the remainder of the vehicle circuits, the printed circuit (17) being arranged on one of the surfaces of the base plate, the connecting pins (24, 25) extending into the base plate, one of their [respective] ends being directly connected to the circuit provided in the casing, and their other [respective] end projecting from the said plate (14) to the outside of the casing to allow connection, the casing comprising a first part (13) integrally moulded from the base plate (14) and the electrical connectors (20, 21), the said base plate being compound-filled around the connecting pins (24, 25), and a heat sink (19) being provided on the surface of the base plate (14) opposite that on which the printed circuit (17) is provided, the base plate being compound-filled around the said heat sink.

2. A casing according to claim 1, **characterised in that** the said pins (24, 25) project from the surface of the base plate (14) opposite that on which the circuit (17) is provided.

3. A casing according to claim 1, **characterised in that** the said pins are angled.

4. A casing according to claim 3, **characterised in that** the said pins project from a lateral surface of the base plate.

5. A casing according to any one of claims 2, 3 or 4, **characterised in that** the pins (24, 25) project perpendicularly or otherwise from the said surface of the base plate.

6. A casing according to any one of the preceding claims, **characterised in that** the surface of the base plate opposite that on which the printed circuit is provided is of a shape adapted to that of a component on which the casing is secured.

7. A casing according to any one of the preceding claims, **characterised in that** the casing includes a second part comprising the cover (15), integrally moulded with the base plate (14) and connected thereto by a region of reduced cross-section forming a joint (16).

## Patentansprüche

1. Gehäuse für elektronische Schaltungen, insbesondere für Kraftfahrzeuge, von der Art, die eine Bodenplatte (14), einen Deckel (15) und eine gedruckte Schaltung (17) aufweist, sowie wenigstens einen Anschlußschalter (20, 21) mit Kontakten (24, 25) für die Verbindung des in dem Gehäuse angeordneten Schaltkreises mit den anderen Schaltkreisen des Fahrzeugs, wobei die gedruckte Schaltung (17) auf einer Fläche der Bodenplatte angeordnet ist und sich die Verbindungskontakte (24, 25) in der Bodenplatte erstrecken, und eines ihrer Enden direkt an den in dem Gehäuse angeordneten Schaltkreis angeschlossen ist, während ihr anderes Ende aus dieser Platte (14) an der Außenseite des Gehäuses hervorsteht, um den Anschluß zu ermöglichen, wobei das Gehäuse einen ersten Teil (13) aufweist, der mit der Bodenplatte (14) und den elektrischen Steckverbindungen einstückig vergossen ist, wobei diese Bodenplatte mit den Anschlußkontakten (24, 25) vergossen ist, und wobei ein Wärmeableiter (19) an der Fläche der Bodenplatte (14) Vorgesehen ist, die derjenigen gegenüberliegt, auf der die gedruckte Schlatung (17) angeordnet ist, wobei die Bodenplatte um diesen Wärmeableiter vergossen ist.

2. Gehäuse nach Anspruch 1,
**dadurch gekennzeichnet**, **daß**
die Kontakte (24, 25) von der Fläche der Bodenplatte (14) hervorstehen, die derjenigen gegenüberliegt, auf der die Schaltung (17) angeordnet ist.

3. Gehäuse nach Anspruch 1,
**dadurch gekennzeichnet, daß**
diese Kontakte gekrümmt sind.

4. Gehäuse nach Anspruch 3,
**dadurch gekennzeichnet, daß**
diese Kontakte aus einer Seitenfläche der Bodenplatte hervorragen.

5. Gehäuse nach einem der Ansprüche 2, 3 oder 4,
**dadurch gekennzeichnet, daß**
die Kontakte (24, 25) rechtwinklig oder nicht rechtwinklig aus dieser Fläche der Bodenplatte hervorragen.

6. Gehäuse nach einem der vorausgegangenen Ansprüche,
**dadurch gekennzeichnet, daß**
die Fläche der Bodenplatte, die derjenigen gegenüberliegt, auf der die gedruckte Schaltung angeordnet ist, eine Form hat, welche derjenigen eines Teils angepaßt ist, auf dem das Gehäuse befestigt ist.

7. Gehäuse nach einem der vorausgegangenen Ansprüche,
**dadurch gekennzeichnet, daß**
das Gehäuse einen zweiten Teil aufweist, welcher den Deckel enthält, der einstückig mit der Bodenplatte (14) vergossen ist und mit diesem in einem Bereich verbunden ist, welcher einen reduzierten Querschnitt aufweist, der ein Gelenk (16) bildet.
